# EUROPÄISCHE PATENTANMELDUNG

(11) **EP 4 701 032 A1**
(43) Veröffentlichungstag der Anmeldung: **25.02.2026**
(21) Anmeldenummer: 25189696.5
(22) Anmeldetag: 15.07.2025
(51) Int. Cl.: H02J 7/00, G01R 31/367

(54) **VERFAHREN UND VORRICHTUNG ZUM BETREIBEN EINER BATTERIE**

(30) Priorität: 19.08.2024 DE 102024207873
(71) Anmelder: Volkswagen Aktiengesellschaft, 38440 Wolfsburg (DE)
(72) Erfinder: Schriever, Udo, 38440 Wolfsburg (DE); Klein, Tobias, 38440 Wolfsburg (DE); Rumberg, Björn, 38440 Wolfsburg (DE); Bedürftig, Benjamin, 38440 Wolfsburg (DE)

(57) **Zusammenfassung**

Die Erfindung betrifft ein Verfahren zum Betreiben einer Batterie (50), wobei die Batterie (50) mittels einer Laderegelung (2) geladen oder entladen wird, wobei zwischen einem vorgegebenen ersten Ladezustand (SCO1) und einem vorgegebenen zweiten Ladezustand (SOC2) mindestens eine Regelgröße (Y) der Laderegelung (2) konstant gehalten wird, wobei zumindest während dieses Konstantabschnitts zwischen dem vorgegebenen ersten Ladezustand (SOC1) und dem vorgegebenen zweiten Ladezustand (SOC2) ein Ladezustand (SOC) der Batterie (50) mittels eines Modells (4) ausgehend von mindestens einer an der Batterie (50) erfassten Messgröße (Z) geschätzt wird. Ferner betrifft die Erfindung eine Vorrichtung (1) zum Betreiben einer Batterie (50).

## Beschreibung

Die Erfindung betrifft ein Verfahren und eine Vorrichtung zum Betreiben einer Batterie.

Li-lonen-Zellen können je nach Temperatur, Bestromungsdauer und Ladezustand nur einen bestimmten Ladestrom aufnehmen, ohne Schaden zu nehmen. Dieser Grenzstrom ändert sich zudem mit einem Alterungszustand der Li-lonen-Zelle. Weiterhin ergibt sich die Schwierigkeit, dass in einem Batteriesystem mehrere Zellen in Serie oder parallel geschaltet sein können, die unterschiedliche Ladezustände, Temperaturen oder Alterungszustände aufweisen. Es ist aktuell daher notwendig, zu jedem Zeitpunkt einen Lade- und Alterungszustand aller Zellen im System, sowie die kälteste und wärmste Stelle zu kennen. Weiter kann eine Ladezustandsverteilung innerhalb des Batteriesystem zwischen den einzelnen Batteriezellen auftreten.

Eine Kenntnis des Ladezustands der Batterie bzw. der Batteriezellen ist wichtig für einen optimalen Betrieb der Batterie.

Der Ladezustand wird beispielsweise bei einer Schnellladung benötigt, da nach dem Stand der Technik ein maximal zulässiger Strom unter anderem vom Ladezustand (Alterung, Temperatur etc.) der Batteriezellen abhängt. Weiter muss darauf geachtet werden, dass die Batteriezellen nicht überladen werden (z.B. nur mit einer Ladeschlussspannung von 3,7 V, 4,2 V, 4,3 V, 4,5 V etc.). Für eine Reichweiten- oder Laufzeitprognose muss der Ladezustand ebenfalls bekannt sein. Weiter darf die Batteriezelle nach dem Stand der Technik während des Betriebs eine definierte Spannung (z.B. 2 V, 2,5 V, 3 V) auch nicht unterschreiten. Ferner darf die Batteriezelle nicht tiefenentladen werden.

Ein Problem hierbei ist, dass durch technisch nicht vermeidbare Fehler (insbesondere bei kostenoptimierten Systemen) bei einer Messung des Stromsignals, der Strom mathematisch integriert nicht exakt der Ladung (Ladezustand) der Batteriezelle entspricht. Weiter kommt es durch Alterungseffekte, passive Anodeneffekte, Selbstentladung und/oder Balancing der Batteriezellen mittels zusätzlicher Elektronik zu weiteren Ungenauigkeiten in der Bestimmung des Ladezustands, da diese Effekte nach dem Stand der Technik nicht durch einen Stromsensor erfasst werden.

Die US 2022 / 0 089 059 A1 beschreibt ein Verfahren zum Betreiben eines Systems zum Ermitteln eines Ladezustands einer Batterie eines Kraftfahrzeugs. Das Verfahren umfasst das Bereitstellen von Betriebsgrößen der Batterie, das Bereitstellen eines berechneten Ladezustands im Kraftfahrzeug unter Verwendung eines Ladezustandsmodells, das einen berechneten Ladezustand in Abhängigkeit von zumindest einem Batteriemodellparameter des Ladezustandsmodells für die Batterie angibt, und das Ermitteln eines Referenzladezustands unter Verwendung eines Referenzladezustandsmodells in Abhängigkeit von den Betriebsgrößen. Das Referenz-Ladezustandsmodell wird trainiert, um den ReferenzLadezustand in Abhängigkeit von Betriebsvariablen und/oder einem vordefinierten Alterungszustand anzuzeigen. Das Verfahren umfasst weiterhin das Durchführen einer Korrektur des mindestens einen Batteriemodellparameters abhängig von einer Differenz zwischen dem Referenzladezustand und dem berechneten Ladezustand, um den berechneten Ladezustand an den Referenzladezustand anzupassen.

Der Erfindung liegt die Aufgabe zu Grunde, ein Verfahren und eine Vorrichtung zum Betreiben einer Batterie, insbesondere im Hinblick auf das Schätzen eines Ladezustands der Batterie, zu verbessern.

Die Aufgabe wird erfindungsgemäß durch ein Verfahren mit den Merkmalen des Patentanspruchs 1 und eine Vorrichtung mit den Merkmalen des Patentanspruchs 10 gelöst. Vorteilhafte Ausgestaltungen der Erfindung ergeben sich aus den Unteransprüchen.

Insbesondere wird ein Verfahren zum Betreiben einer Batterie zur Verfügung gestellt, wobei die Batterie mittels einer Laderegelung geladen oder entladen wird, wobei zwischen einem vorgegebenen ersten Ladezustand und einem vorgegebenen zweiten Ladezustand mindestens eine Regelgröße der Laderegelung konstant gehalten wird (bzw. konstant ist), wobei zumindest während dieses Konstantabschnitts zwischen dem vorgegebenen ersten Ladezustand und dem vorgegebenen zweiten Ladezustand ein Ladezustand der Batterie mittels eines Modells ausgehend von mindestens einer an der Batterie erfassten Messgröße geschätzt wird.

Ferner wird insbesondere eine Vorrichtung zum Betreiben einer Batterie geschaffen, umfassend eine Laderegelung, die eingerichtet ist zum geregelten Laden oder Entladen der Batterie, und eine Datenverarbeitungseinrichtung, wobei die Laderegelung dazu eingerichtet ist, zwischen einem vorgegebenen ersten Ladezustand und einem vorgegebenen zweiten Ladezustand mindestens eine Regelgröße der Laderegelung konstant zu halten, wobei die Datenverarbeitungseinrichtung dazu eingerichtet ist, mindestens eine an der Batterie erfasste Messgröße zu erhalten und zumindest während des Konstantabschnitts zwischen dem vorgegebenen ersten Ladezustand und dem vorgegebenen zweiten Ladezustand einen Ladezustand der Batterie mittels eines Modells ausgehend von der mindestens einen an der Batterie erfassten Messgröße zu schätzen.

Das Verfahren und die Vorrichtung ermöglichen es, einen Ladezustand der Batterie verbessert zu schätzen. Hierzu wird die Batterie in einem Konstantabschnitt zwischen einem vorgegebenen ersten Ladezustand und einem vorgegebenen zweiten Ladezustand geregelt geladen oder entladen. Hierbei, das heißt in dem Konstantabschnitt, wird mindestens eine Regelgröße der Laderegelung konstant gehalten. Hierdurch haben andere Größen, welche einen Zustand der Batterie beschreiben, einen definierten ladezustandsabhängigen Verlauf. Ein solcher Verlauf kann insbesondere mittels eines Modells, beispielsweise in Form von Kennlinien (bzw. Kennfeldern), beschrieben werden. Zumindest während des Konstantabschnitts zwischen dem vorgegebenen ersten Ladezustand und dem vorgegebenen zweiten Ladezustand wird ein Ladezustand der Batterie mittels eines Modells ausgehend von mindestens einer an der Batterie erfassten Messgröße geschätzt. Insbesondere kann das Modell den Ladezustand ausgehend von dem bekannten Verlauf der mindestens einen Messgröße schätzen. Der Vorteil ist, dass die mindestens eine konstante Regelgröße bekannt ist und daher insbesondere weniger Größen an der Batterie erfasst und/oder geschätzt werden müssen. Durch den definierten Verlauf der mindestens einen Messgröße in Bezug auf den Ladezustand kann der Verlauf vom Modell zum Schätzen des Ladezustands genutzt werden. Die Schätzung des Ladezustands lässt sich hierdurch verbessern. Der ausgehend von der erfassten mindestens einen Messgröße geschätzte Ladezustand wird insbesondere bei der Laderegelung berücksichtigt.

Der Konstantabschnitt umfasst insbesondere einen Bereich von mindestens 50 %, bevorzugt mindestens 60 %, besonders bevorzugt mindestens 70 % der gesamten Ladungsmenge, die in der Batterie gespeichert werden kann. Entsprechend sind der erste Ladezustand und der zweite Ladezustand vorgegeben. Der erste Ladezustand und der zweite Ladezustand sind hierbei vorab (d.h. insbesondere vor Ladebeginn und gegebenenfalls vor dem Ladeende) insbesondere derart zu wählen, dass eine Batterieschädigung, welche über ein normal zu erwartendes Maß (beispielsweise von 0,0001 % bis 1 % Schädigung pro Ladezyklus) hinausgeht, vermieden wird. Das normal zu erwartende Maß der Batterieschädigung pro Ladezyklus wird beispielsweise vorab mittels Batteriealterungstests bestimmt. Die Regelgröße, welche in diesem Konstantabschnitt konstant gehalten wird, darf insbesondere auch kleiner/geringer gewählt werden als physikalisch möglich.

Es ist insbesondere vorgesehen, dass der Konstantabschnitt, das heißt, die Werte für den ersten Ladezustand und den zweiten Ladezustand, und ein Wert der mindestens einen Regelgröße derart gewählt werden, dass technisch vorgegebene Betriebsparameter der Batterie bzw. der Batteriezellen (z.B. eine Maximalspannung etc.) eingehalten werden.

Es ist insbesondere vorgesehen, dass das Modell mit Hilfe von geeigneten Daten parametriert wird oder parametriert wurde. Insbesondere ist vorgesehen, dass zum Parametrieren des Modells eine Vielzahl von Ladevorgängen und/oder Entladevorgängen unter verschiedenen Randbedingungen durchgeführt wird oder durchgeführt wurde, wobei ein Ladezustand jeweils gesondert bestimmt wird. Gesondert meint hierbei insbesondere mittels eines Verfahrens, welches unabhängig von dem in dieser Offenbarung beschriebenen Verfahren ist bzw. den Ladezustand auf andere Weise bestimmt. Ein solches Verfahren kann beispielsweise mit Hilfe einer Stromintegration mittels Batteriemessgeräten und/oder Leerlaufspannung-Ladezustand-Kurven etc. arbeiten. Die Randbedingungen bzw. die Daten umfassen hierbei unterschiedliche Startladezustände, einen konstanten Wert der mindestens einen Regelgröße und verschiedene Werte der Messgröße und/oder, bei mehreren Messgrößen, Kombinationen der mindestens einen Messgröße. Ausgehend von diesen Daten wird das Modell derart parametriert, dass das Modell die Daten bei Anwenden des Modells bestmöglich reproduzieren kann, das heißt, dass eine Abweichung zwischen einem von dem Modell geschätzten Ladezustand und dem gesondert bestimmten Ladezustand minimiert ist.

Es kann vorgesehen sein, dass die Vorrichtung in ein Batteriemanagementsystem integriert ist.

Teile der Vorrichtung, insbesondere die Laderegelung und/oder die Datenverarbeitungseinrichtung, können einzeln oder zusammengefasst als eine Kombination von Hardware und Software ausgebildet sein, beispielsweise als Programmcode, der auf einem Mikrocontroller oder Mikroprozessor ausgeführt wird. Es kann jedoch auch vorgesehen sein, dass Teile einzeln oder zusammengefasst als anwendungsspezifische integrierte Schaltung (ASIC) und/oder feldprogrammierbares Gatterfeld (FPGA) ausgebildet sind.

In einer Ausführungsform ist vorgesehen, dass die mindestens eine Regelgröße eine Zellspannung umfasst. Die Zellspannung wird im Konstantabschnitt dann konstant gehalten. Hierdurch hat insbesondere eine Stromstärke einen definierten Verlauf. Insbesondere wird bei dieser Ausführungsform die Stromstärke als Messgröße erfasst. Aufgrund der bekannten mindestens einen Regelgröße und des definierten Verlaufs der Stromstärke in Bezug auf den Ladezustand kann das Modell den Ladezustand der Batterie verbessert schätzen.

Es ist insbesondere vorgesehen, dass das Verfahren für jede (Einzel-)Batteriezelle angewendet wird. Nach dem Stand der Technik wird eine Spannung für jede einzelne Batteriezelle in einem Batteriesystem erfasst, wobei bei parallel geschalteten Batteriezellen meist nur eine Spannung erfasst wird. In diesem Fall wird insbesondere auch für jede einzelne Batteriezelle im Batteriesystem ein Ladezustand bestimmt und auch für die Laderegelung (Batteriebetrieb) benötigt.

In einer Ausführungsform ist vorgesehen, dass die mindestens eine erfasste Messgröße eine Stromstärke oder eine Ladeleistung umfasst. Dies ermöglicht eine einfache Messung mit Hilfe eines Stromsensors.

In einer Ausführungsform ist vorgesehen, dass die mindestens eine erfasste Messgröße eine Temperatur umfasst. Hierdurch kann der Ladezustand verbessert geschätzt werden, da die Temperatur einen starken Einfluss auf die Ladezustandsschätzung hat. Die Temperatur wird beispielsweise mittels eines Temperatursensors erfasst.

In einer Ausführungsform ist vorgesehen, dass das Modell ein trainiertes Maschinenlernmodell ist oder ein solches umfasst. Hierdurch kann ein Modell bereitgestellt werden, das für jeden Wert der mindestens einen Messgröße einen Ladezustand schätzen kann. Das Maschinenlernmodell kann beispielsweise ein künstliches Neuronales Netz sein oder ein solches umfassen. Das Maschinenlernmodell wird beispielsweise mit Hilfe von geeigneten Trainingsdaten trainiert. Die Trainingsdaten werden insbesondere aus den voranstehend beschriebenen Daten erzeugt. Beispielsweise können für ein überwachtes Lernen des Maschinenlernmodells Datenpaare erzeugt werden, in denen jeweils Messgrößen mit dem (gesondert bestimmten) Ladezustand (als Grundwahrheit) gepaart sind. Mit diesen Datenpaaren wird das Maschinenlernmodell in an sich bekannter Weise im Wege des überwachten Lernens trainiert. Nach dem Training kann das trainierte Maschinenlernmodell ausgehend von gleichartigen Eingangsdaten, das heißt, der erfassten mindestens einen Messgröße, einen Ladezustand schätzen.

In einer Ausführungsform ist vorgesehen, dass das Modell in Form von mindestens einer Kennlinie und/oder einer Nachschlagetabelle ausgebildet ist oder eine solche umfasst. Die Kennlinie und/oder die Nachschlagetabelle verknüpfen die mindestens eine Messgröße mit einem Wert für den Ladezustand. Hierdurch kann das Modell mit wenig Rechenaufwand bereitgestellt werden. Die Kennlinie und die Nachschlagetabelle können insbesondere mehrdimensional mit mehr als einer Eingangsdimension sein. Beispielsweise können als Eingangsdimensionen die Messgrößen Stromstärke, Temperatur und SOH (engl. state of health) vorgesehen sein. Es kann vorgesehen sein, dass die Kennlinie als Funktion hinterlegt ist, beispielsweise als mehrdimensionale Polynomfunktion.

In einer Ausführungsform ist vorgesehen, dass ein SOH-Wert der Batterie geschätzt wird und dem Modell zusätzlich als Eingangsgröße zugeführt wird.

In einer Ausführungsform ist vorgesehen, dass zum Parametrieren des Modells eine Vielzahl von Ladevorgängen und/oder Entladevorgängen unter verschiedenen Randbedingungen durchgeführt wird oder durchgeführt wurde. Dies wurde voranstehend bereits beschrieben.

In einer Ausführungsform ist vorgesehen, dass ein Erreichen des vorgegebenen zweiten Ladezustands durch Vergleichen mit dem geschätzten Ladezustand überprüft wird, wobei das Laden oder Entladen mit der mindestens einen konstanten Regelgröße beendet wird, wenn das Vergleichsergebnis ergibt, dass der vorgegebene zweite Ladezustand erreicht ist. Insbesondere kann nach Erreichen des zweiten Ladezustands, insbesondere oberhalb des zweiten Ladezustands, ein anderer Wert der Regelgröße gesetzt werden, beispielsweise um durch Laden den Ladezustand bis zu einem vorgegebenen Maximalladezustand zu erhöhen.

Weitere Merkmale zur Ausgestaltung der Vorrichtung ergeben sich aus der Beschreibung von Ausgestaltungen des Verfahrens. Die Vorteile der Vorrichtung sind hierbei jeweils die gleichen wie bei den Ausgestaltungen des Verfahrens.

Nachfolgend wird die Erfindung anhand bevorzugter Ausführungsbeispiele unter Bezugnahme auf die Figuren näher erläutert. Hierbei zeigen:
- Fig. 1: eine schematische Darstellung einer Ausführungsform der Vorrichtung zum Betreiben einer Batterie;
- Fig. 2: eine schematische Darstellung einer Kurve, die die Regelgröße über dem Ladezustand darstellt, zur Verdeutlichung der Erfindung;
- Figuren 3a bis 3d: schematische Darstellungen von Verläufen der Regelgröße und von Messgrößen über der Zeit, zur Verdeutlichung einer Ausführungsform;
- Fig. 4: eine schematische Darstellung von Verläufen der Stromstärke über dem Ladezustand für unterschiedliche Randbedingungen (Startladezustände);
- Fig. 5: eine schematische Darstellung zur Verdeutlichung des Verfahrens und der Vorrichtung;
- Fig. 6: ein schematisches Ablaufdiagramm einer Ausführungsform des Verfahrens.

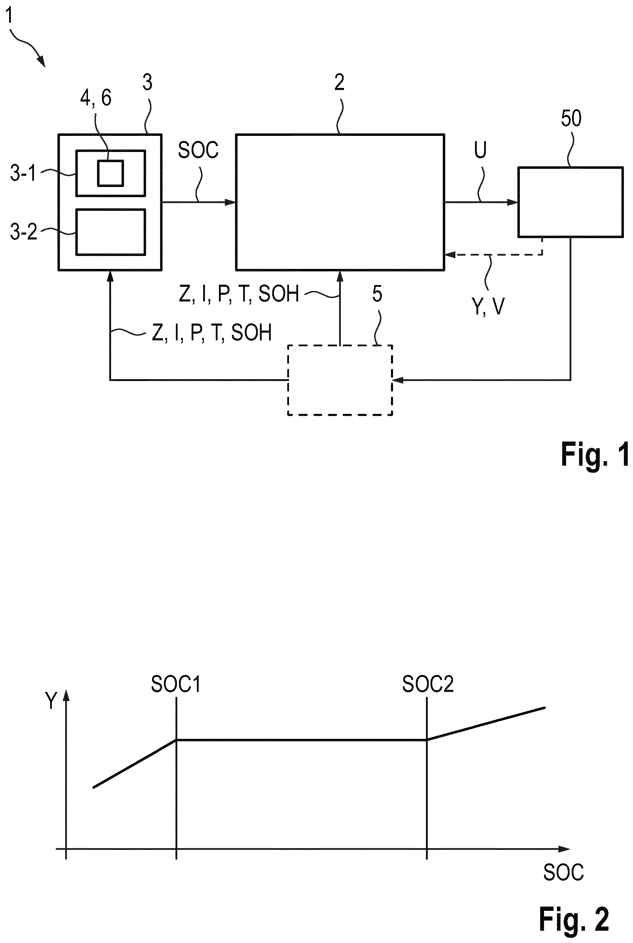

Die Fig. 1 zeigt eine schematische Darstellung einer Ausführungsform der Vorrichtung 1 zum Betreiben einer Batterie 50. Die Vorrichtung 1 umfasst eine Laderegelung 2 und eine Datenverarbeitungseinrichtung 3. Die Vorrichtung 1 ist insbesondere dazu eingerichtet, das in dieser Offenbarung beschriebene Verfahren auszuführen.

Die Laderegelung 2 ist dazu eingerichtet, zwischen einem vorgegebenen ersten Ladezustand SOC1 und einem vorgegebenen zweiten Ladezustand SOC2 mindestens eine Regelgröße Y der Laderegelung 2 konstant zu halten. Die Laderegelung 2 ist ansonsten in an sich bekannter Weise ausgebildet. Insbesondere ermittelt die Laderegelung 2 anhand einer Regelabweichung zwischen einem Sollwert der mindestens einen Regelgröße Y und einem erfassten Istwert der mindestens einen Regelgröße Y eine Stellgröße U, welche gestellt wird.

Die Datenverarbeitungseinrichtung 3 weist beispielsweise eine Recheneinrichtung 3-1 und einen Speicher 3-2 auf. Die Recheneinrichtung 3-1 ist dazu eingerichtet, zum Durchführen des Verfahrens notwendige Rechenoperationen auszuführen, und kann hierzu auf in dem Speicher 3-2 hinterlegte Daten zugreifen.

Die Datenverarbeitungseinrichtung 3 ist dazu eingerichtet, mindestens eine an der Batterie 50 erfasste Messgröße Z zu erhalten und zumindest während des Konstantabschnitts zwischen dem vorgegebenen ersten Ladezustand SOC1 und dem vorgegebenen zweiten Ladezustand SOC2 einen Ladezustand SOC der Batterie 50 mittels eines Modells 4 ausgehend von der mindestens einen an der Batterie 50 erfassten Messgröße Z zu schätzen.

Zum Erfassen der mindestens einen Messgröße Z an der Batterie 50 kann eine Sensorik 5 vorgesehen sein. Die Sensorik 5 kann Teil der Vorrichtung 1 sein.

Es ist insbesondere vorgesehen, dass die erfasste mindestens eine Messgröße Z an die Laderegelung 2 übermittelt wird und von dieser beim Regeln berücksichtigt wird.

Die Fig. 2 zeigt eine schematische Darstellung einer Kennlinie zur Verdeutlichung des Verfahrens und der Vorrichtung. Zwischen dem vorgegebenen ersten Ladezustand SOC1 und dem vorgegebenen zweiten Ladezustand SOC2 liegt der Konstantabschnitt, in dem die Laderegelung 2 (Fig. 1) die mindestens eine Regelgröße Y konstant hält. Bei einem Ladezustand SOC, der kleiner als SOC1 oder größer als SOC2 ist, kann die Regelgröße Y andere Werte aufweisen.

Es kann vorgesehen sein, dass die mindestens eine Regelgröße Y eine Zellspannung V umfasst. Die Stellgröße U ist dann beispielsweise eine Stromstärke I.

Es kann vorgesehen sein, dass die mindestens eine erfasste Messgröße Z eine Stromstärke I oder eine Ladeleistung P umfasst.

Es kann vorgesehen sein, dass die mindestens eine erfasste Messgröße Z eine Temperatur T umfasst. Diese wird beispielsweise mittels eines Temperatursensors (nicht gezeigt) an Batteriezellen der Batterie erfasst.

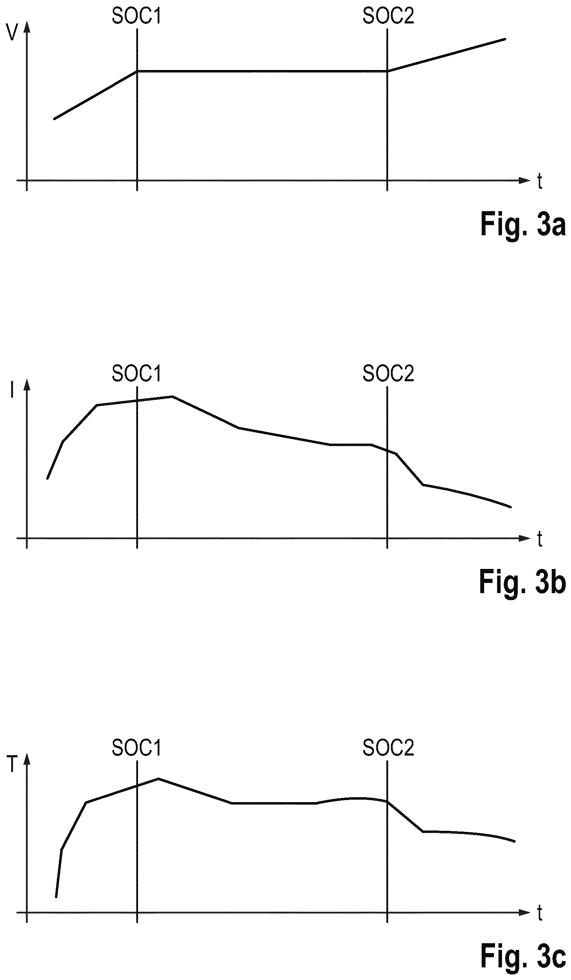

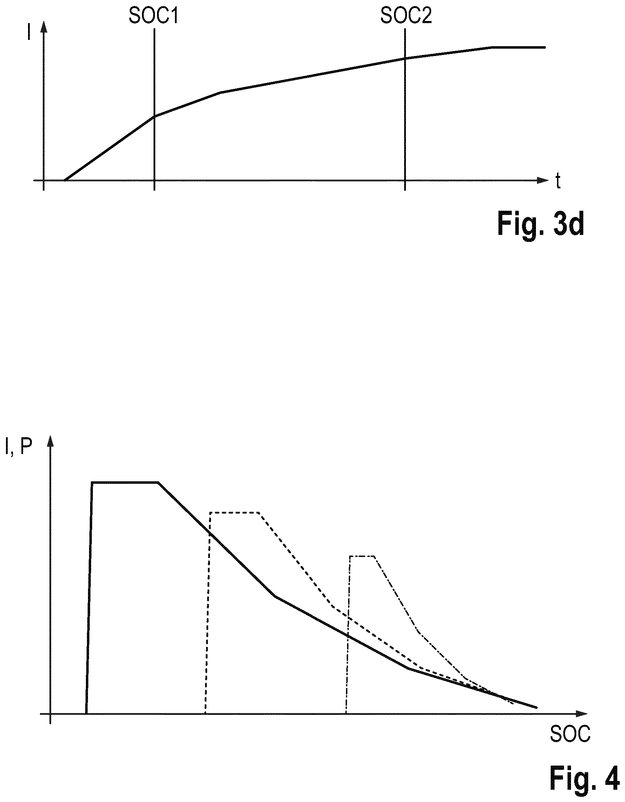

Die Figuren 3a bis 3d zeigen schematische Darstellungen der Kurvenverläufe für die Zellspannung V, die Stromstärke I, die Temperatur T und den Ladezustand SOC, jeweils dargestellt über der Zeit t. Die Kurven beinhalten hierbei nur beispielhafte Werte und dienen lediglich der Verdeutlichung des Verfahrens und der Vorrichtung. Die Kurven haben in Abhängigkeit von einem Startladezustand jeweils definierte Verläufe, deren Kenntnis sich das in dieser Offenbarung beschriebene Verfahren zunutze macht.

Das Modell 4 (Fig. 1) wird mit Hilfe von geeigneten empirischen und/oder simulierten Daten parametriert. Hierzu ist insbesondere vorgesehen, dass eine Vielzahl von Ladevorgängen an der Batterie 50 (bzw. eines gleichartigen Batteriemodells) durchgeführt wird, wobei dies unter verschiedenen Randbedingungen erfolgt, insbesondere in Bezug auf einen Startladezustand, einen Endladezustand und/oder eine Temperatur. Für das Entladen kann das gleiche erfolgen. Die mindestens eine Regelgröße wird hierbei jedoch konstant gehalten.

Die Fig. 4 zeigt beispielhaft schematische Darstellungen von drei Kurven, bei denen das Laden bei verschiedenen Startladezuständen erfolgt ist. Gezeigt ist jeweils die Stromstärke I bzw. eine Ladeleistung P über dem (gesondert bestimmten) Ladezustand SOC. Ausgehend von diesen Kurven wird das Modell 4 beispielsweise parametriert. Im Ergebnis soll das Modell 4 die Kurven möglichst gut repräsentieren können. Anders ausgedrückt: Ausgehend von einem bekannten Startladezustand und dem jeweils zugehörigen Kurvenverlauf kann mit Hilfe der Stromstärke I oder der Ladeleistung P der Ladezustand SOC geschätzt werden.

Es kann vorgesehen sein, dass ein SOH-Wert (engl. state of health) der Batterie 50 geschätzt wird und dem Modell 4 zusätzlich als Eingangsgröße zugeführt wird. Entsprechend ist vorgesehen, dass beim Parametrieren des Modells 4 als weitere Eingangsdaten der SOH-Wert berücksichtigt wird. Ein SOH-Wert kann beispielsweise bestimmt werden, indem eine beim Laden übertragene Energiemenge bestimmt wird, beispielsweise ausgehend von einer Ladeleistung P und einer Zeitdauer, die in Beziehung gesetzt wird zu einer Änderung des Ladezustands SOC. Werden beispielsweise 50 kWh in die Batterie geladen und ändert sich ein (prozentualer) Ladezustand SOC von 25 % auf 75 %, so entspricht dies einer Änderung von 50 %. Weist die Batterie 50 eine Gesamtkapazität von beispielsweise 100 kWh auf, so ist der SOH-Wert bei 100 % (50 kWh/50 % = 100 kWh). Werden jedoch nur beispielsweise 40 kWh in die Batterie 50 geladen und ändert sich der Ladezustand SOC hierbei ebenfalls von 25 % auf 75 %, so ergibt sich bei gleicher Gesamtkapazität ein SOH-Wert, der nur noch 80 % (40 kWh/50 % = 80 kWh) der Gesamtkapazität beträgt.

Es kann vorgesehen sein, dass das Modell 4 ein trainiertes Maschinenlernmodell 6 (Fig. 1) ist oder ein solches umfasst. Das Maschinenlernmodell 6 kann insbesondere ein künstliches Neuronales Netz sein oder ein solches umfassen. Ausgehend von den voranstehend beschriebenen Kurven kann das Maschinenlernmodell 6 trainiert werden. Hierzu werden aus den Kurven beispielsweise Trainingsdaten erzeugt, umfassend Paare, die jeweils einen Startladezustand und eine Stromstärke bzw. eine Ladeleistung P gepaart mit einem Wert für den Ladezustand SOC umfassen. Das Maschinenlernmodell 6 wird dann in an sich bekannter Weise mittels dieser Trainingsdaten trainiert, insbesondere im Wege des überwachten Lernens.

Es kann vorgesehen sein, dass das Modell 4 in Form von mindestens einer Kennlinie und/oder einer Nachschlagetabelle ausgebildet ist oder eine solche umfasst. Die mindestens eine Kennlinie und/oder die Nachschlagetabelle bildet dann insbesondere die Kurven ab, welche in der Fig. 4 gezeigt sind. Beispielsweise kann vorgesehen sein, eine Kennlinie mit den unabhängigen Variablen Stromstärke I bzw. Ladeleistung P, Temperatur T und SOH und der hiervon abhängigen Variable Ladezustand SOC zu verwenden. Alternativ kann vorgesehen sein, eine Nachschlagetabelle mit den unabhängigen Variablen Stromstärke I bzw. Ladeleistung P, Temperatur T und SOH und der jeweils zugeordneten Variable Ladezustand SOC zu verwenden.

Es kann vorgesehen sein, dass ein Erreichen des vorgegebenen zweiten Ladezustands SOC2 (Fig. 1) durch Vergleichen mit dem geschätzten Ladezustand SOC überprüft wird, wobei Laden oder Entladen mit der mindestens einen konstanten Regelgröße Y beendet wird, wenn das Vergleichsergebnis ergibt, dass der vorgegebene zweite Ladezustand SOC2 erreicht ist.

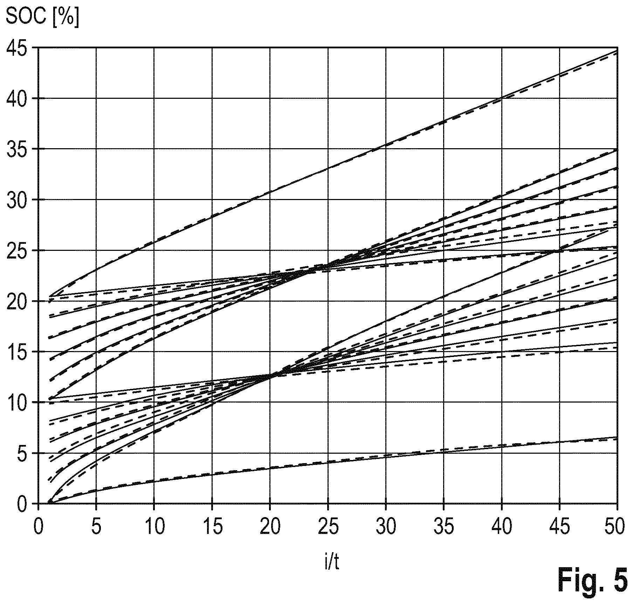

Die Fig. 5 zeigt eine schematische Darstellung zur Verdeutlichung des Verfahrens und der Vorrichtung. Gezeigt sind auf der y-Achse ein gemessener Ladezustand (durchgezogene Kurve) bzw. der mittels des Modells geschätzte Ladezustand SOC (gestrichelte Kurve) in der Einheit Prozent. Auf der x-Achse ist der Messpunkt i (sample point) bzw. die Zeit t gezeigt. Das verwendete Modell ist ein trainiertes Maschinenlernmodell, das als Eingangsdaten die Stromstärke I, die Temperatur T und die Ladungsmenge Q/60 erhält. Die Ladungsmenge Q ist insbesondere das Integral des Stromes und wird hier in der Einheit Ampere Sekunden (As) verwendet. Eine Normierung (Skalierung) auf Ampere Minuten (= 60 Sekunden) zeigte eine vorteilhafte Schätzqualität (daher die Bezeichnung Q/60). Zu erkennen ist, dass die Schätzung des Maschinenlernmodells für sämtliche Kurven während des Konstantabschnitts sehr gut mit dem jeweils gemessenen Wert übereinstimmt.

Es kann grundsätzlich vorteilhaft sein, die gemessenen Größen zu skalieren, bevor diese im Modell verarbeitet werden, wie dies voranstehend beispielhaft an der Ladungsmenge gezeigt wurde.

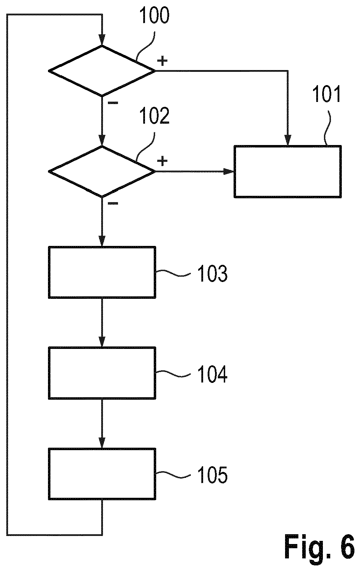

Die Fig. 6 zeigt ein schematisches Ablaufdiagramm zur Verdeutlichung einer Ausführungsform des Verfahrens zum Betreiben einer Batterie. Das Verfahren wird beispielsweise mittels einer Vorrichtung gemäß der in der Fig. 1 gezeigten Ausführungsform ausgeführt.

In einem Verfahrensschritt 100 wird überprüft, ob ein Ladezustand SOC der Batterie kleiner als ein vorgegebener erster Ladezustand SOC1 ist. Initial kann der Ladezustand SOC hierfür beispielsweise anhand einer Leerlaufspannungs-Ladezustands-Kurve (OCV-SOC-Kurve) in an sich bekannter Weise geschätzt werden. Ist dies der Fall, so wird mit Verfahrensschritt 101 fortgefahren, wobei das Verfahren insbesondere beendet wird. Es ist insbesondere vorgesehen, dass unterhalb des ersten Ladezustands SOC1 mit einem anderen Verfahren geladen oder entladen wird.

Ist der Ladezustand SOC größer als der vorgegebene erste Ladezustand SOC1, so wird mit Verfahrensschritt 102 fortgefahren. Im Verfahrensschritt 102 wird überprüft, ob der Ladezustand SOC größer als ein vorgegebener zweiter Ladezustand SOC2 ist. Ist dies der Fall, so wird mit Verfahrensschritt 101 fortgefahren, wobei das Verfahren insbesondere beendet wird. Es ist insbesondere vorgesehen, dass oberhalb des zweiten Ladezustands SOC2 mit einem anderen Verfahren geladen oder entladen wird.

Ist der Ladezustand SOC nicht größer als der vorgegebene zweite Ladezustand SOC2, so wird mit Verfahrensschritt 103 fortgefahren. Im Verfahrensschritt 103 wird die Batterie mittels der Laderegelung mit mindestens einer konstanten Regelgröße geladen (oder entladen). Die mindestens eine konstante Regelgröße kann insbesondere eine Zellspannung sein.

In einem Verfahrensschritt 104 wird mindestens eine Messgröße an der Batterie erfasst. Die mindestens eine Messgröße wird mittels einer geeigneten Sensorik an Batteriezellen der Batterie und/oder an der Batterie erfasst. Die mindestens eine Messgröße umfasst beispielsweise eine Stromstärke und/oder eine Temperatur. Es wird insbesondere auch die mindestens eine Regelgröße erfasst und zum Bestimmen einer Regelabweichung verwendet.

In einem Verfahrensschritt 105 wird ein Ladezustand SOC der Batterie mittels eines Modells ausgehend von mindestens einer an der Batterie erfassten Messgröße geschätzt.

Anschließend, das heißt in einem nachfolgenden Zeitschritt, wird zu Verfahrensschritt 100 zurückgekehrt, wobei in den Verfahrensschritten 100 und 102 beim Überprüfen der mittels des Modells geschätzte Ladezustand SOC verwendet wird.

### Bezugszeichenliste

- 1: Vorrichtung
- 2: Laderegelung
- 3: Datenverarbeitungseinrichtung
- 3-1: Recheneinrichtung
- 3-2: Speicher
- 4: Modell
- 5: Sensorik
- 6: Maschinenlernmodell
- 50: Batterie
- 100-105: Verfahrensschritte
- SOC: Ladezustand
- SOC1: vorgegebener erster Ladezustand
- SOC2: vorgegebener zweiter Ladezustand
- SOH: Gesundheitszustand (state of health)
- i: Messpunkt (sample)
- t: Zeit
- I: Stromstärke
- T: Temperatur
- P: Ladeleistung
- U: Stellgröße
- V: (Zell-)Spannung
- Y: (mindestens eine) Regelgröße
- Z: (mindestens eine) Messgröße

## Patentansprüche

1. Verfahren zum Betreiben einer Batterie (50),
wobei die Batterie (50) mittels einer Laderegelung (2) geladen oder entladen wird, wobei zwischen einem vorgegebenen ersten Ladezustand (SCO1) und einem vorgegebenen zweiten Ladezustand (SOC2) mindestens eine Regelgröße (Y) der Laderegelung (2) konstant gehalten wird,
wobei zumindest während dieses Konstantabschnitts zwischen dem vorgegebenen ersten Ladezustand (SOC1) und dem vorgegebenen zweiten Ladezustand (SOC2) ein Ladezustand (SOC) der Batterie (50) mittels eines Modells (4) ausgehend von mindestens einer an der Batterie (50) erfassten Messgröße (Z) geschätzt wird.

2. Verfahren nach Anspruch 1, **dadurch gekennzeichnet, dass** die mindestens eine Regelgröße (Y) eine Zellspannung (V) umfasst.

3. Verfahren nach Anspruch 1 oder 2, **dadurch gekennzeichnet, dass** die mindestens eine erfasste Messgröße (Z) eine Stromstärke (I) oder eine Ladeleistung (P) umfasst.

4. Verfahren nach einem der vorangegangenen Ansprüche, **dadurch gekennzeichnet, dass** die mindestens eine erfasste Messgröße (Z) eine Temperatur (T) umfasst.

5. Verfahren nach einem der vorangegangenen Ansprüche, **dadurch gekennzeichnet, dass** das Modell (4) ein trainiertes Maschinenlernmodell (6) ist oder ein solches umfasst.

6. Verfahren nach einem der vorangegangenen Ansprüche, **dadurch gekennzeichnet, dass** das Modell (4) in Form von mindestens einer Kennlinie und/oder einer Nachschlagetabelle ausgebildet ist oder eine solche umfasst.

7. Verfahren nach einem der vorangegangenen Ansprüche, **dadurch gekennzeichnet, dass** ein SOH-Wert (SOH) der Batterie (50) geschätzt wird und dem Modell (4) zusätzlich als Eingangsgröße zugeführt wird.

8. Verfahren nach einem der vorangegangenen Ansprüche, **dadurch gekennzeichnet, dass** zum Parametrieren des Modells (4) eine Vielzahl von Ladevorgängen und/oder Entladevorgängen unter verschiedenen Randbedingungen durchgeführt wird oder durchgeführt wurde.

9. Verfahren nach einem der vorangegangenen Ansprüche, **dadurch gekennzeichnet, dass** ein Erreichen des vorgegebenen zweiten Ladezustands (SOC2) durch Vergleichen mit dem geschätzten Ladezustand (SOC) überprüft wird, wobei das Laden oder Entladen mit der mindestens einen konstanten Regelgröße (Y) beendet wird, wenn das Vergleichsergebnis ergibt, dass der vorgegebene zweite Ladezustand (SOC2) erreicht ist.

10. Vorrichtung (1) zum Betreiben einer Batterie (50), umfassend:
eine Laderegelung (2), die eingerichtet ist zum geregelten Laden oder Entladen der Batterie (50), und eine Datenverarbeitungseinrichtung (3),
wobei die Laderegelung (2) dazu eingerichtet ist, zwischen einem vorgegebenen ersten Ladezustand (SOC1) und einem vorgegebenen zweiten Ladezustand (SOC2) mindestens eine Regelgröße (Y) der Laderegelung (2) konstant zu halten,
wobei die Datenverarbeitungseinrichtung (3) dazu eingerichtet ist, mindestens eine an der Batterie (50) erfasste Messgröße (Z) zu erhalten und zumindest während des Konstantabschnitts zwischen dem vorgegebenen ersten Ladezustand (SOC1) und dem vorgegebenen zweiten Ladezustand (SOC2) einen Ladezustand (SOC) der Batterie (50) mittels eines Modells (4) ausgehend von der mindestens einen an der Batterie (50) erfassten Messgröße (Z) zu schätzen.
